# EUROPÄISCHE PATENTSCHRIFT

(11) **EP 1 072 054 B1**
(45) Veröffentlichungstag und Bekanntmachung des Hinweises auf die Patenterteilung: **15.06.2005**
(21) Anmeldenummer: 99920641.0
(22) Anmeldetag: 12.04.1999
(51) Int. Cl.: H01J 37/34, C23C 14/34

(54) **HALTERING SOWIE TARGET UND VERFAHREN ZU SEINER HERSTELLUNG**
RETAINING RING AND TARGET AND METHOD FOR PRODUCING SAME
BAGUE DE SUPPORT AINSI QUE CIBLE ET PROCEDE POUR SA FABRICATION

(30) Priorität: 16.04.1998 EP 98106874
(43) Veröffentlichungstag der Anmeldung: 31.01.2001
(73) Patentinhaber: Unaxis Balzers Aktiengesellschaft, 9496 Balzers (LI)
(72) Erfinder: STUCKI, Hans-Ulrich, CH-9477 Trübbach (CH); SIEGL, Wolfgang, A-6812 Meiningen (AT)
(74) Vertreter: Wagner, Wolfgang, Dr. Phil., Dipl.-Phys.
(86) Internationale Anmeldenummer: PCT/EP1999/002447
(87) Internationale Veröffentlichungsnummer: WO 1999/054910

(56) Entgegenhaltungen:
- EP-A- 0 499 770
- EP-A- 0 512 456
- WO-A-96/24947

## Beschreibung

Die Erfindung betrifft einen Haltering zur Befestigung einer Targetplatte in einer Haltevorrichtung eines Prozessraums, insbesondere einer Vakuumkammer, ein Target, das einen derartigen Haltering und eine Targetplatte umfasst sowie ein Verfahren zu seiner Herstellung. Targets werden bei verschiedenen Beschichtungsprozessen eingesetzt, bei welchen durch Ionenbeschuss die Oberfläche der Targetplatte zerstäubt oder verdampft und die freigesetzten Partikel auf einem Werkstück abgesetzt werden. Das Target wird dabei allmählich aufgebraucht.

Aus der EP-A-0 499 770 ist ein einstückig aus Targetmaterial hergestelltes Target bekannt, welches radial nach aussen abstehende, gleichmässig über seinen Umfang verteilte und durch Zwischenräume getrennte, gegenüber einer Oberseite des Targets zurückgesetzte Verankerungsfortsätze aufweist, welche dazu dienen, das Target in einer Halterung zu verankern. Die Halterung weist entsprechende nach innen weisende Haltevorsprünge auf, die nach Drehung des Targets die Verankerungsfortsätze übergreifen, so dass dasselbe bajonettverschlussartig fixiert ist, wobei die Verankerungsfortsätze zusätzlich durch eine gegen die Unterseite des Targets drückende Metallfolie einer Kühlvorrichtung gegen die Haltevorsprünge gedrückt wird. Dies hat den Nachteil, dass die Verankerungsfortsätze bei jedem der verhältnismässig rasch aufgebrauchten Targets durch einen komplizierten Bearbeitungsvorgang hergestellt werden müssen, wobei u. U. ein verhältnismässig grosser Teil des oft kostspieligen Targetmaterials verloren geht.

Der Erfindung liegt die Aufgabe zugrunde, eine Befestigung des Targets anzugeben, bei welcher die Form der aus Targetmaterial bestehenden Targetplatte keinen durch die Erfordernisse ihrer Verankerung vorgegebenen besonderen Anforderungen gerecht werden muss sowie ein entsprechendes Target. Diese Aufgabe wird durch die Merkmale im kennzeichnenden Teil des Anspruchs 1 bzw. des Anspruch 6 gelöst. Ausserdem soll ein besonders einfaches Herstellungsverfahren für das Target angegeben werden. Diese Aufgabe wird durch die Merkmale im kennzeichnenden Teil des Anspruchs 10 gelöst.

Die durch die Erfindung erreichten Vorteile sind vor allem darin zu sehen, dass die Targetfunktion von der Verankerungsfunktion entkoppelt ist und daher am Targetmaterial allenfalls eine sehr einfache, eine ausreichende Verbindung mit dem die Verankerung übernehmenden Haltering sicherstellende Nachbearbeitung vorgenommen werden muss. Der die Verankerungsfortsätze tragende, komplizierter geformte Haltering besteht dagegen aus einem resistenten Material und ist wiederverwendbar. Die vorgeschlagene Nachbearbeitung der Targetplatte ist sehr einfach auszuführen und hat nur geringe Materialverluste zur Folge.

Im folgenden wird die Erfindung anhand von Figuren, welche lediglich ein Ausführungsbeispiel darstellen, näher erläutert. Es zeigen
- Fig. 1: eine Draufsicht auf ein erfindungsgemässes Target und
- Fig. 2: einen Schnitt längs II-II in Fig. 1 durch das Target sowie durch einen Teil einer Haltevorrichtung.

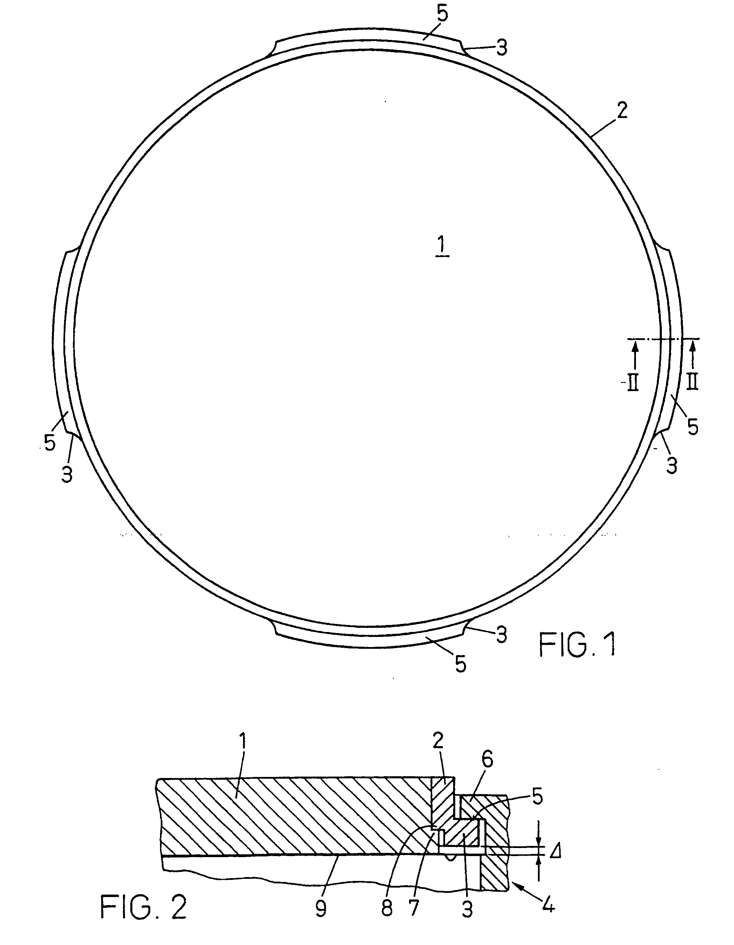

Das Target besteht aus einer ebenen runden Targetplatte 1 aus einem für den jeweiligen Beschichtungsprozess geeigneten Targetmaterial, z. B. Aluminium. Auf dieselbe ist ein Haltering 2 aufgeschoben, der sie umgibt, so dass seine Innenseite an ihrer Aussenseite anliegt. Er besteht aus einem resistenten Material, z. B. Titan. Die Oberseite des Halterings 2 ist mit der Oberseite der Targetplatte 1 plan. Sie bildet einen schmalen Kreisring, dessen Fläche gegenüber der Oberfläche der Targetplatte 1 nicht ins Gewicht fällt. An seiner Aussenseite weist der Haltering 2 vier gleichmässig über seinen Umfang verteilte, radial nach aussen abstehende und durch grössere Zwischenräume getrennte Verankerungsfortsätze 3 auf, welche gegenüber seiner Oberseite um etwa zwei Drittel der Höhe des Halterings 2 zurückgesetzt sind. Sie dienen der Verankerung des Targets in einer Haltevorrichtung 4 und bilden nach oben weisende Befestigungswangen 5, die in der in Fig. 2 dargestellten, durch Einsetzen und Drehen des Targets 1 erreichten Verriegelungsstellung gegen die Unterseiten von vier Haltevorsprüngen 6 drücken, die, nach innen vorspringend, ebenfalls gleichmässig über den Umfang einer Aufnahmeöffnung der Haltevorrichtung 4 verteilt sind und die Verankerungsfortsätze 3 übergreifen.

An der Aussenseite der Targetplatte 1 bildet eine umlaufende Stufe einen nach oben weisenden Gegenanschlag 7, der mit einem entsprechenden nach unten weisenden Anschlag 8 an der Innenseite des Halterings 2 zusammenwirkt, der von einer umlaufenden Stufe gebildet wird und daher gegenüber der Unterseite des Halterings 2 etwas zurückgesetzt ist, jedoch unterhalb der Befestigungswangen 5 liegt. Der Gegenanschlag 7 an der Targetplatte 1 kann auf einfache Weise und mit geringem Materialverlust aus einer zylindrischen Platte gleichmässiger Dicke hergestellt werden, indem die Stufe z. B. durch Drehen von der Oberseite her angelegt wird. Der Gegenanschlag 7 wird dabei so eingestellt, dass sein Abstand zur Unterseite der Targetplatte 1 grösser ist als derjenige des Anschlags 8 am Haltering 2 von dessen Unterseite, so dass die Targetplatte 1 um eine Höhendifferenz Δ über die gleichfalls ebene Unterseite des Halterings 2 nach unten vorsteht.

Daher drückt eine Metallfolie 9 der Haltevorrichtung 4, hinter welcher zur Kühlung der Targetplatte 1 eine unter Druck stehende Kühlflüssigkeit vorbeigeleitet wird, gegen deren Unterseite, während sie vom Haltering 2 beabstandet ist. Auf diese Weise wird nicht nur ein optimaler Wärmeübergang erzielt, sondern auch über den Gegenanschlag 7 und den Anschlag 8 zwischen den Befestigungswangen 5 und den Unterseiten der Haltevorsprünge 3 ein Anpressdruck erzeugt und das Target sicher in der Haltevorrichtung 4 eingespannt.

Seitlich bleibt zwischen dem Target und der Haltevorrichtung 4 etwas Spiel, so dass bei thermischer Ausdehnung des Targets, das während des Beschichtungsprozesses eine verhältnismässig hohe Temperatur, z. B. 400°C, erreichen kann, keine Spannungen auftreten. Die Targetplatte 1 kann einer etwas grösseren thermischen Ausdehnung unterworfen sein als der Haltering 2, so dass sich diese Teile während des Beschichtungsprozesses verklemmen. Nach Abkühlung des Targets kann der Haltering 2 jedoch abgenommen werden, so dass dies nicht weiter stört.

Es sind verschiedene Abwandlungen in der Ausbildung des Halterings und auch der Targetplatte möglich. So kann etwa der Gegenanschlag statt durch eine Stufe auch durch den an den Innenrand des Halterings anschliessenden Teil seiner Unterseite gebildet werden. Anschlag und Gegenanschlag können auch konisch ausgebildet sein.

## Patentansprüche

1. Haltering (2) zur Befestigung einer Targetplatte (1) in einer Haltevorrichtung (4) eines Prozessraums, **dadurch gekennzeichnet, dass** er an der Aussenseite mehrere radial nach aussen abstehende, über seinen Umfang verteilte und durch Zwischenräumen getrennte Verankerungsfortsätze (3) aufweist, welche gegen eine Oberseite des Halterings (2) weisende Befestigungswangen (5) für die Verankerung desselben in der Haltevorrichtung (4) bilden sowie an der Innenseite einen gegen die Unterseite des Halterings (2) weisenden Anschlag (8).

2. Haltering (2) nach Anspruch 1, **dadurch gekennzeichnet, dass** er mindestens drei Verankerungsfortsätze (3) aufweist, welche gleich ausgebildet und gleichmässig verteilt sind.

3. Haltering (2) nach Anspruch 1 oder 2, **dadurch gekennzeichnet, dass** die Befestigungswangen (5) gegenüber einem oberen Rand des Halterings (2) zurückgesetzt sind.

4. Haltering nach Anspruch 4, **dadurch gekennzeichnet, dass** der Anschlag (8) gegenüber einer Unterseite desselben zurückgesetzt ist.

5. Haltering nach Anspruch 4, **dadurch gekennzeichnet, dass** der Anschlag (8) durch eine umlaufende Stufe gebildet wird.

6. Target mit einer Targetplatte (1) sowie einem Haltering (2) nach einem der Ansprüche 1 bis 5, **dadurch gekennzeichnet, dass** der Haltering (2) die Targetplatte (1) umgibt und dieselbe an ihrem Rand einen nach oben weisenden Gegenanschlag (7) aufweist, welcher an dem nach unten weisenden Anschlag (8) am Haltering (2) anliegt.

7. Target nach Anspruch 6, **dadurch gekennzeichnet, dass** die Unterseite der Targetplatte (1) gegenüber der Unterseite des Halterings (2) vorsteht.

8. Target nach Anspruch 6 oder 7, **dadurch gekennzeichnet, dass** der Gegenanschlag (7) gegenüber der Oberseite der Targetplatte (1) zurückgesetzt ist und dieselbe mit der Oberseite des Halterings (2) plan ist.

9. Target nach Anspruch einem der Ansprüche 6 bis 8, **dadurch gekennzeichnet, dass** der Gegenanschlag (7) der Targetplatte (1) als umlaufende Stufe ausgebildet ist.

10. Verfahren zur Herstellung eines Targets nach Anspruch 9, **dadurch gekennzeichnet, dass** die umlaufende Stufe an der Targetplatte (1) durch Drehen angelegt wird.

## Claims

1. Retaining ring (2) for fastening a target plate (1) in a holding device (4) of a process room, **characterized in that** it has, on the outside, a plurality of anchoring extensions (3) which project radially outwards and are distributed over its circumference and separated by spaces and form fastening cheeks (5) which face the upper surface of the retaining ring (2) and are intended for anchoring said retaining ring in the holding device (4) and, on the inside, a stop (8) facing the lower surface of the retaining ring (2).

2. Retaining ring (2) according to Claim 1, **characterized in that** it has at least three anchoring extensions (3) which are identically formed and uniformly distributed.

3. Retaining ring (2) according to Claim 1 or 2, **characterized in that** the fastening cheeks (5) are recessed relative to an upper edge of the retaining ring (2).

4. Retaining ring according to Claim 4, **characterized in that** the stop (8) is recessed relative to a lower surface of said retaining ring.

5. Retaining ring according to Claim 4, **characterized in that** the stop (8) is formed by an all-round step.

6. Target comprising a target plate (1) and a retaining ring (2) according to any of Claims 1 to 5, **characterized in that** the retaining ring (2) surrounds the target plate (1) and the latter has, at its edge, an upward-facing opposite stop (7) which rests against the downward-facing stop (8) on the retaining ring (2).

7. Target according to Claim 6, **characterized in that** the lower surface of the target plate (1) projects relative to the lower surface of the retaining ring (2).

8. Target according to Claim 6 or 7, **characterized in that** the opposite stop (7) is recessed relative to the upper surface of the target plate (1) and the latter is flush with the upper surface of the retaining ring (2).

9. Target according to any of Claims 6 to 8, **characterized in that** the opposite stop (7) of the target plate (1) is in the form of an all-round step.

10. Process for the production of a target according to Claim 9, **characterized in that** the all-round step is created on the target plate (1) by turning.

## Revendications

1. Bague de support (2) pour la fixation d'une plaque cible (1) dans un dispositif de support (4) d'une chambre de procédé, **caractérisée en ce qu'**elle présente sur la face externe plusieurs prolongements d'ancrage (3) qui dépassent radialement vers l'extérieur, sont répartis sur sa circonférence et sont séparés par des espaces, lesdits prolongements d'ancrage formant des joues de fixation (5) situées en direction d'une face supérieure de la bague de support (2) et destinées à ancrer ladite bague de support dans le dispositif de support (4), et sur la face interne une butée (8) située en direction de la face inférieure de la bague de support (2).

2. Bague de support (2) selon la revendication 1, **caractérisée en ce qu'**elle présente au moins trois prolongements d'ancrage (3), de conception identique et répartis régulièrement.

3. Bague de support (2) selon la revendication 1 ou 2, **caractérisée en ce que** les joues de fixation (5) sont situées en retrait par rapport à un bord supérieur de la bague de support (2).

4. Bague de support selon la revendication 3, **caractérisée en ce que** la butée (8) est située en retrait par rapport à une face inférieure de ladite bague de support.

5. Bague de support selon la revendication 4, **caractérisée en ce que** la butée (8) est formée par un gradin périphérique.

6. Cible avec une plaque cible (1) ainsi qu'avec une bague de support (2) selon l'une des revendications 1 à 5, **caractérisée en ce que** la bague de support (2) entoure la plaque cible (1) et que ladite plaque cible présente sur son bord une contre-butée (7) donnant vers le haut et adjacente à la butée (8) - de la bague de support (2) - qui donne vers le bas.

7. Cible selon la revendication 6, **caractérisée en ce que** la face inférieure de la plaque cible (1) dépasse par rapport à la face inférieure de la bague de support (2).

8. Cible selon la revendication 6 ou 7, **caractérisée en ce que** la contre-butée (7) est située en retrait par rapport à la face supérieure de la plaque cible (1) et que ladite face supérieure de la plaque cible forme un seul plan avec la face supérieure de la bague de support (2).

9. Cible selon l'une des revendications 6 à 8, **caractérisée en ce que** la contre-butée (7) de la plaque cible (1) est conçue comme un gradin périphérique.

10. Procédé pour la fabrication d'une cible selon la revendication 9, **caractérisé en ce que** le gradin périphérique de la plaque cible (1) est réalisé par tournage.
